# EUROPEAN PATENT SPECIFICATION

(11) **EP 2 955 757 B1**
(45) Date of publication and mention of the grant of the patent: **18.09.2019**
(21) Application number: 14748959.5
(22) Date of filing: 27.01.2014
(51) Int. Cl.: H01L 29/778, H01L 29/78, H01L 29/872, H01L 29/10, H01L 29/423, H01L 29/20, H01L 29/40, H01L 29/205

(54) **NITRIDE POWER COMPONENT AND MANUFACTURING METHOD THEREFOR**
NITRIDLEISTUNGSKOMPONENTE UND HERSTELLUNGSVERFAHREN DAFÜR
COMPOSANT ÉLECTRIQUE EN NITRURE ET PROCÉDÉ DE FABRICATION ASSOCIÉ

(30) Priority: 07.02.2013 CN 201310049854
(43) Date of publication of application: 16.12.2015
(73) Proprietor: Enkris Semiconductor, Inc., 215123 Suzhou City (CN)
(72) Inventor: CHENG, Kai, Suzhou City, Jiangsu 215123 (CN)
(74) Representative: ABG Intellectual Property Law, S.L.
(86) International application number: PCT/CN2014/071559
(87) International publication number: WO 2014/121710

(56) References cited:
- CN-A- 102 299 071
- CN-A- 102 306 659
- CN-A- 102 306 659
- CN-A- 102 903 738
- CN-A- 103 117 303
- JP-A- 2010 040 814
- US-A- 5 060 030
- US-A1- 2009 166 677
- US-A1- 2012 153 355
- ZHANG, BO ET AL.: 'Breakdown Voltage Analysis of a REBULF LDMOS Structure with an n+ Floating Layer' CHINESE JOURNAL OF SEMICONDUCTORS vol. 27, no. 4, 30 April 2006, page 730, 731 AND 733, XP008181104

## Description

### TECHNICAL FIELD

The present invention relates to microelectronics technology, in particular, relates to a nitride power device and manufacturing method thereof in which a semiconductor doped multiplayer structure forming a relatively thick space charge depletion region is disposed in a Si substrate and thus a relatively high external voltage can be withstood, thereby improving breakdown voltage of the device.

### BACKGROUND

As the third-generation semiconductor material, Gallium Nitride (GaN) has become a hot research topic due to its features such as large band gap, high electron saturation velocity, high breakdown voltage and good thermal conductivity. In aspects of electrical devices, compared with silicon and gallium arsenide, gallium nitride material is more suitable to be used to manufacture electronic devices which is capable of withstanding high temperature, high pressure, high frequency and has high power, thus gallium nitride based electronic devices have broad application prospects.

In the past, gallium nitride power devices were manufactured on sapphire substrates or silicon carbide substrates. Due to particularity and processing difficulty of gallium nitride heterojunction conductive channels, most gallium nitride power devices have flat structures. Because of thick substrates and high breakdown voltages, the devices are usually broken down transversely. Although some plane optimization techniques, such as using field plate structure and increasing the distance between a gate electrode and a drain electrode, can increase the breakdown voltages of the devices, the materials used for sapphire substrates and silicon carbide substrates are expensive and difficult to manufacture substrates and epitaxial layers with large sizes, so the gallium nitride power devices are costly and difficult to be commercialized.

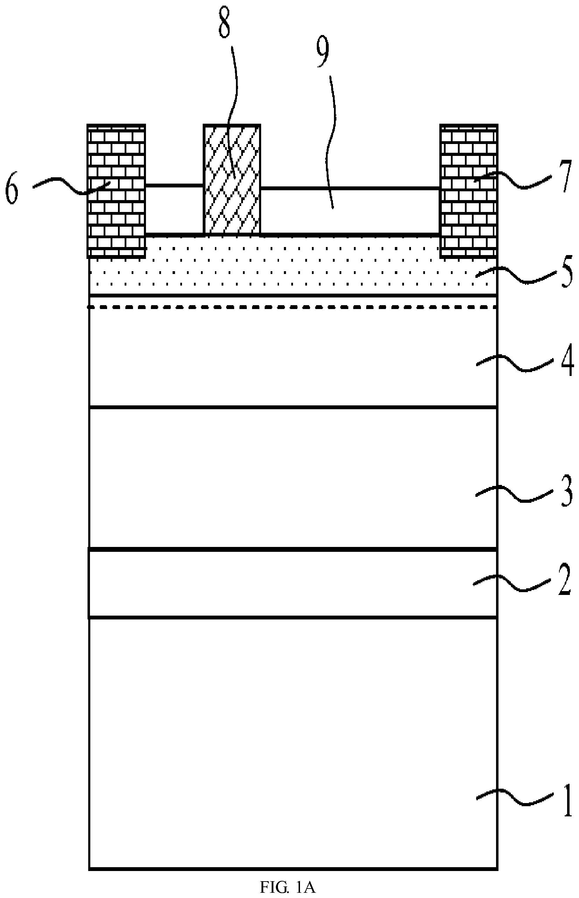

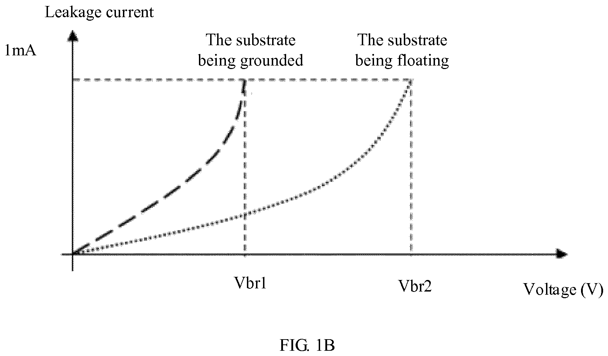

At present, the technology of manufacturing gallium nitride power devices on large-size silicon substrates is becoming mature and costs are lowering, which facilitates commercialization of gallium nitride power devices. Taking a gallium nitride power device having a triode structure as an example, as shown in FIG. 1A, the device comprises a silicon substrate 1, a nitride nucleation layer 2, a nitride buffer layer 3, a nitride channel layer 4, a nitride barrier layer 5, a dielectric passivation layer 9 and three electrodes including a source electrode 6, a drain electrode 7 and a gate electrode 8. Due to the electrical conductivity of the silicon materials and their low critical electric fields, every silicon-based gallium nitride power device has a saturation breakdown voltage, which is determined by the thickness of the nitride epitaxial layer grown on a silicon substrate. In addition, to avoid electrostatic discharge (ESD) caused by accumulation of static electricity in the devices and realize voltage matching in the circuits, it is necessary to ground the substrates, which reduces a breakdown voltage Vbr1 when a substrate of a silicon-based gallium nitride power device is grounded to half of a breakdown voltage Vbr2 when the substrate is floating as shown in FIG. 1B. Even high resistance zone melting silicon is adopted, since the resistivity of the high resistance zone melting silicon is usually less than 10⁴ Ohm.cm which is far less than the resistivity of nitride (> 10⁹ Ohm.cm), thus the purpose of sharing voltages cannot be realized. Therefore, improving breakdown voltage of the nitride power devices on the silicon substrates is an urgent problem currently.

The breakdown voltages of the nitride high voltage devices on the silicon substrates can be improved by increasing the thickness of epitaxial layers. Although the technology of growing nitride epitaxial layers on the silicon material is becoming mature, the thickness of nitride epitaxial layers is limited to about 2um to 4um due to the huge lattice mismatch and thermal mismatch between the silicon material and nitride. Growing an epitaxial layer with excessive thickness not only requires a long time, increases costs and reduces yield, but also deteriorates quality of the epitaxial layers which makes it easy to warp or crack and thereby increases processing difficulty and reduces yield.

When the substrate is grounded, the breakdown voltage of the device is also affected by longitudinal breakdown. Such a longitudinal breakdown voltage is determined by a bearable voltage of the epitaxial layer and that of the silicon substrate. Therefore, a total longitudinal breakdown voltage can be increased by improving the bearable voltage of the silicon substrate.

The thickness of the silicon substrate is usually fixed. Excessive thickness will increase the cost, affect the quality of the nitride epitaxial layer on the silicon substrate, and increase the processing difficulty. Therefore, it is infeasible to improve the bearable voltage of the silicon substrate by increasing its thickness.

In the silicon semiconductor devices, PN diodes made of silicon can withstand very high reverse external voltages. Generally, an N-type doped region and a P-type doped region are formed by doping in the silicon substrate and a PN junction is formed inside the two doped regions, and hence a space charge depletion region is formed. Similar to a high resistance region, there are few conductive electrons and holes, or even none, inside the space charge depletion region, so the space charge depletion region has a high breakdown electric field and can withstand a certain external voltage. The bearable voltage of the space charge region depends on its width. The wider the space charge region is, the higher voltage it can withstand, that is, the higher the breakdown voltage of the PN diode is. The width of the space charge region is affected by the doping concentration and the external voltage. Generally, the space charge region widens as the external voltage increases. Under the same external voltage, the space charge region is wider under a low doping concentration than that under a high doping concentration, and can withstand a higher external voltage. After the electrons and the holes inside the N-type doped region and the P-type doped region are completely exhausted, the space charge region will no longer widen. In this case, increasing the external voltage continually will breakdown the space charge region. With the existing mature and stable silicon doping technology, doping distribution can be performed to form different structures and different concentrations, which produces PN diodes with different bearable voltages.

US20120153355A1 discloses a nitride semiconductor device including a semiconductor substrate, and a nitride semiconductor layer formed on the semiconductor substrate. The semiconductor substrate includes a normal region and an interface current block region surrounding the normal region. The nitride semiconductor layer includes an element region and an isolation region surrounding the element region. The element region is formed over the normal region. The interface current block region contains impurities, and forms a potential barrier against carriers generated at an interface between the nitride semiconductor layer and the semiconductor substrate.

JP2010040814A discloses a semiconductor device which has a protection element and is enhanced in use efficiency of an epitaxial layer surface. A PN diode is connected between a source electrode and a drain electrode of a GaN-HFET.

CN102306659A discloses an LDMOS (laterally double-diffused metal-oxide-semiconductor field effect transistor) device based on internal electric field modulation. The device comprises a first conduction-type substrate layer and a second conduction-type drift layer arranged on the first conduction-type substrate layer; and the first conduction-type substrate layer is internally provided with a floating empty region, wherein the floating empty region is formed by alternation and overlapping of a plurality of first conduction-type floating empty layers and a plurality of second conduction-type floating empty layers at the horizontal direction.

### SUMMARY

According to the present invention a manufacturing method is provided according to claim 1.

### BRIEF DESCRIPTION OF DRAWINGS

The features, advantages and objects of the present invention will become apparent and more readily appreciated from the following description of the examples useful for understanding the invention or the embodiments, taken in conjunction with the accompanying drawings in which:
FIG. 1A is a schematic structural view illustrating an existing nitride power device on a Si substrate;
FIG. 1B illustrates breakdown voltages of the nitride power device on the silicon substrate in cases of being floating and being grounded respectively;
FIG. 2A is a schematic structural view illustrating a nitride power device according to a first example useful for understanding the present invention;
FIG. 2B illustrates a modified structure of the first example useful for understanding the present invention;
FIG. 2C illustrates another modified structure of the first example useful for understanding the present invention;
FIG. 3 illustrates a modified structure of the first example useful for understanding the present invention;
FIG. 4 illustrates a structure which can be manufactured according to the present invention;
FIG. 5 illustrates another modified structure of the first example useful for understanding the present invention;
FIG. 6 is a schematic structural view illustrating a nitride power device on a silicon substrate according to a second example useful for understanding the present invention;
FIG. 7 is a schematic structural view illustrating a nitride power device on a silicon substrate according to a third example useful for understanding the present invention;
FIG. 8 is a schematic structural view illustrating a nitride power device on a silicon substrate according to a fourth example useful for understanding the present invention;
FIG. 9 is a schematic structural view illustrating a nitride power device on a silicon substrate according to a fifth example useful for understanding the present invention;
FIG. 10 is a schematic structural view illustrating a nitride power device on a silicon substrate according to a sixth example useful for understanding the present invention;
FIG. 11 is a schematic structural view illustrating a nitride power device on a silicon substrate according to a seventh example useful for understanding the present invention;
FIG. 12 is a schematic structural view illustrating a nitride power device on a silicon substrate according to an eighth example useful for understanding the present invention.

### DETAILED DESCRIPTION

As described in the section of Background, in the existing nitride power devices on silicon substrates, when the silicon substrates are grounded, the longitudinal breakdown voltages of the devices will be reduced half, which greatly increases the breakdown risk of the devices.

In order to overcome the shortcomings of the prior art, the present invention provides a method for manufacturing a nitride power device which is capable of withstanding high breakdown voltage, in which pn junctions having n-type silicon layers and p-type silicon layers in an alternating arrangement are disposed in a silicon substrate. When an external voltage is applied to the nitride power device, each pn junction forms a space charge depletion region. By means of stacking one or more space charge depletion regions, breakdown voltage is greatly increased for the device, thus reducing the risk of the device being broken down by a voltage.

Hereinafter examples useful for understanding the invention or embodiments of the present invention will be described in detail with reference to the accompanying drawings.

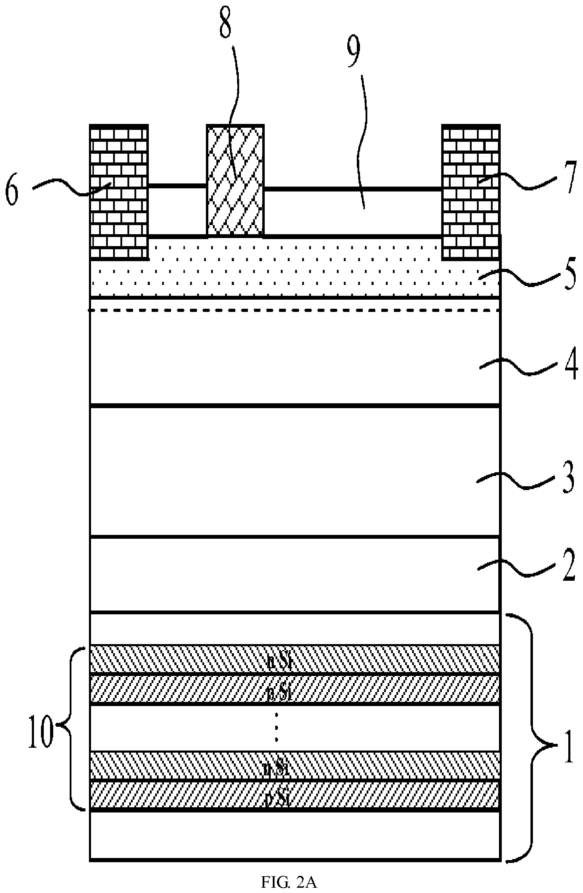

Referring to FIG. 2A which is a schematic structural view illustrating a nitride power device according to a first example useful for understanding the present invention, in this example, taking a field-effect transistor (FET) with a triode structure as example, a nitride power device comprises: a silicon substrate 1 including a semiconductor doped multilayer structure 10 forming a space charge depletion region and an epitaxial multilayer structure on the silicon substrate 1. The epitaxial multilayer structure includes a nitride nucleation layer 2 and a buffer layer 3. The buffer layer 3 contains GaN, A1N or other nitrides, and is used to match substrate material and high quality nitride epitaxial layer, and also affects crystal quality, surface morphology, electrical property and other parameters of heterojunctions made by GaN/AlGaN thereon. A channel layer 4 including a non-doped GaN layer is grown on the buffer layer 3. A barrier layer 5 including AlGaN or other nitrides is grown on the channel layer 4, and forms a semiconductor heterojunction structure together with the channel layer 4. High-concentration two-dimensional electron gas is formed at the interface and a conductive channel is formed at the heterojunction interface in the GaN channel layer. A dielectric layer 9 is deposited on the barrier layer 5 to protect a surface of the material through passivation. The dielectric layer includes one selected from SiN, Si02, SiON, Al₂O₃, HfO₂, HfAlOx or any combination thereof. A groove is etched in the dielectric layer 9 between the source electrode 6 and the drain electrode 7 and metal is deposited on the groove so that a gate electrode 8 is formed. In the present example, the horizontal semiconductor doped multilayer structure 10 forming a space charge depletion region is introduced in the silicon substrate, which brings an innovation point of the present example. The semiconductor doped multilayer structure can be one pn junction formed by one n-type semiconductor layer and one p-type semiconductor layer, or multiple pn junctions formed by multiple p-type semiconductor layers and multiple n-type semiconductor layers in an alternating arrangement. The semiconductor layer is very thin, with a thickness being larger than 2nm. The semiconductor layer can be formed by epitaxial growth or ion implantation. The number of layers, thickness and doping concentration of the whole semiconductor doped multilayer structure can be adjusted according to the required bearable voltage. The doping concentration of the n-type and p-type semiconductors can be very low, that is, n-type and p-type semiconductors can be formed. When an external forward voltage is applied to the drain electrode and the substrate is grounded, each pn junction forms a space charge depletion region, thus the whole semiconductor doped multilayer structure forms a thick space charge depletion region which is capable of withstanding a high voltage. In this way, the breakdown voltage of the device is greatly increased. It will be understood that since an FET is taken as an example of the power device in this example, the epitaxial multilayer structure on the substrate includes the barrier layer on the channel layer and the dielectric layer on the surface of the barrier layer; however, the power device can be a semiconductor device for another function. Therefore, in the present invention, the epitaxial multilayer structure at least includes a nucleation layer, a buffer layer and a nitride channel layer when it is used for a specific function.

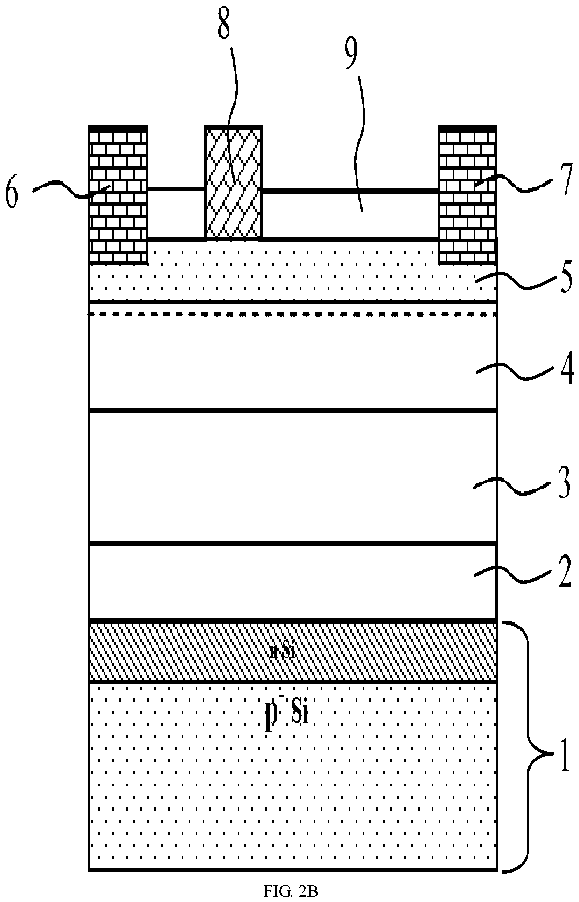

FIG. 2B illustrates a modified structure of the first example useful for understanding the present invention. Different from FIG. 2A, the silicon substrate 1 in FIG. 2B is formed by lightly-doped p-type and n-type silicon. When a forward voltage is applied to the drain electrode and the substrate is grounded, the silicon substrate 1 is similar to a reverse pn junction forming a space charge depletion region which can withstand a certain voltage. Thus the breakdown voltage of the device is increased.

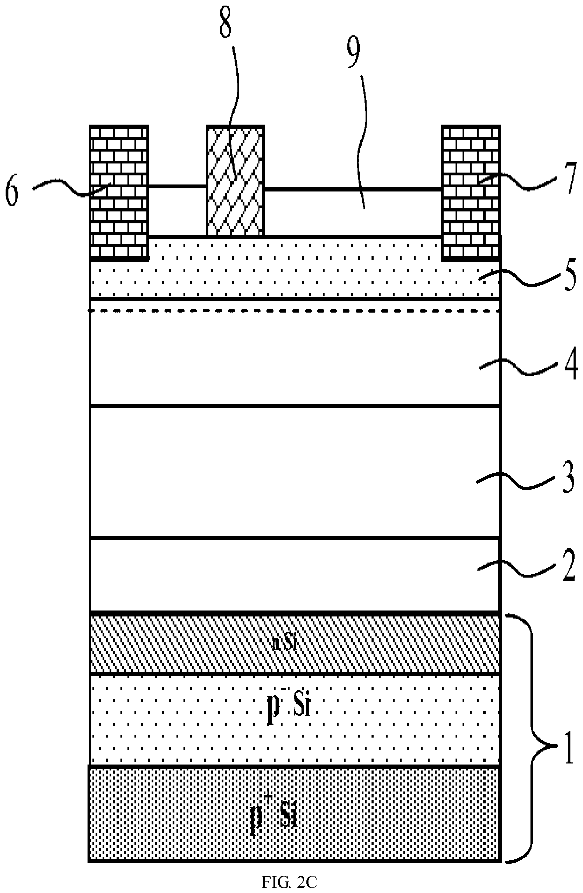

FIG. 2C illustrates another modified structure of the first example useful for understanding the present invention. Different from FIG.s 2A and 2B, the silicon substrate 1 in FIG. 2C has a three-layer structure formed by heavily-doped p+ silicon, lightly-doped p- silicon and n silicon. The function of the silicon substrate 1 is the same as that of the silicon substrate 1 in FIG.s 2A and 2B, the repeated description will be omitted.

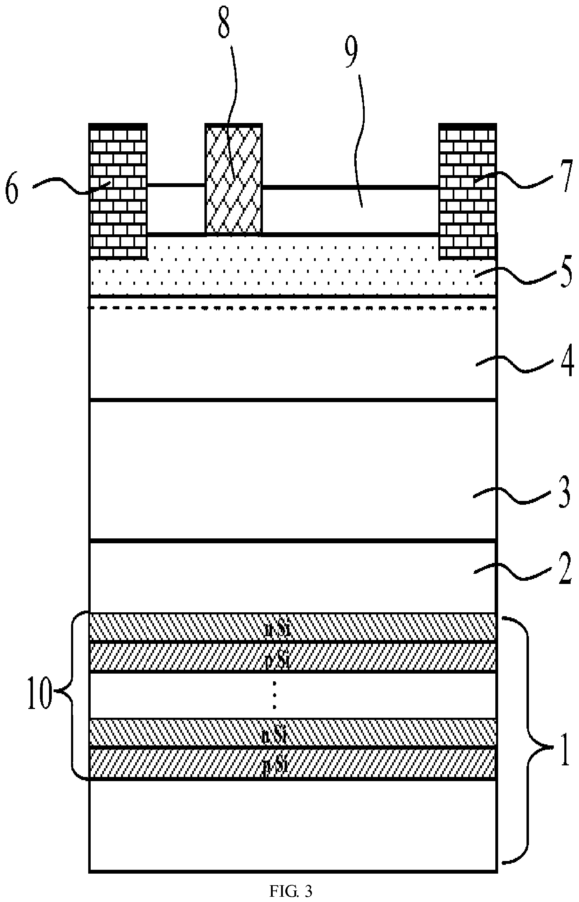

FIG. 3 illustrates a modified structure of the first example useful for understanding the present invention. As shown in FIG. 3, an epitaxial growth process or a doping process is performed at the top of the silicon substrate so that the semiconductor doped multilayer structure is formed at the top of the silicon substrate. The nitride nucleation layer 2 and the buffer layer 3 and the like can be grown on the semiconductor doped multilayer structure directly. Compared with the semiconductor doped multilayer structure which is located in the interior of the silicon substrate as shown in FIG. 2, the manufacturing process of this structure is relatively simplified.

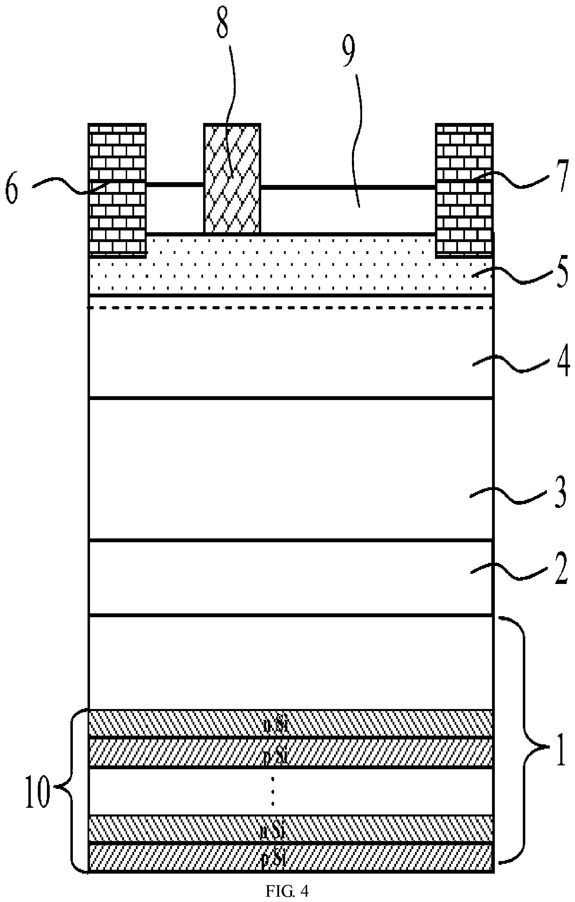

FIG. 4 illustrates a structure which can be manufactured according to the present invention. As shown in FIG. 4, an epitaxial growth process is performed at the bottom of the silicon substrate so that the semiconductor doped multilayer structure is formed at the bottom of the silicon substrate. Compared with the semiconductor doped multilayer structure which is located at the top of the silicon substrate as shown in FIG. 3, difficulty of the process of growing the nitride nucleation layer 2 and the buffer layer 3 on the semiconductor doped multilayer structure directly is reduced.

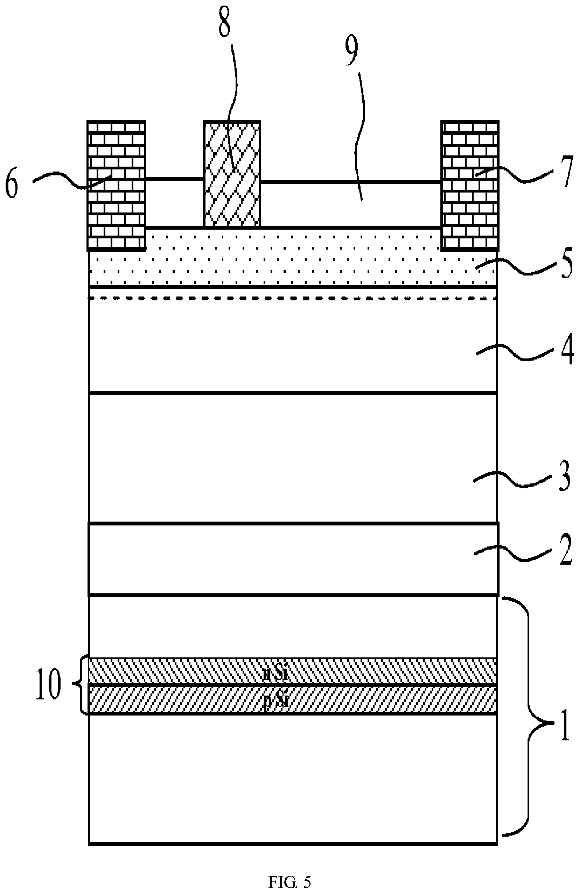

FIG. 5 illustrates another modified structure of the first example useful for understanding the present invention. Generally, the number of layers and thickness of the semiconductor doped multilayer structure is determined by the required bearable voltage. If the external voltage is not too high, the semiconductor doped multilayer structure does not need to be very thick, and the process can be simplified. As shown in FIG. 5, the semiconductor doped multilayer structure 10 is formed by one n-type semiconductor layer and one p-type semiconductor layer. The n-type semiconductor layer is adjacent to the nitride epitaxial layer. The n-type semiconductor layer can be a thick lightly-doped semiconductor layer, and the p-type semiconductor layer can be a thin heavily-doped semiconductor layer. When a forward voltage is applied to the drain electrode and the substrate is grounded, the semiconductor doped bilayer structure is similar to a reverse pn junction forming a space charge depletion region which can withstand a certain voltage. Thus the breakdown voltage of the device is increased. The semiconductor-doped bilayer structure can be located at the top or the bottom of the silicon substrate.

A method for manufacturing the nitride power device according to an embodiment includes the following steps: epitaxially growing a semiconductor doped multilayer structure forming a space charge depletion region on a bottom major surface of a silicon substrate; growing a nitride nucleation layer on a top major surface of the silicon substrate including the semiconductor doped multilayer structure; growing a nitride buffer layer on the nitride nucleation layer; growing a nitride channel layer on the nitride buffer layer; and forming contact electrodes on the nitride channel layer.

The semiconductor doped multilayer structure is manufactured by epitaxial growth. The semiconductor doped multilayer structure is manufactured at the bottom of the silicon substrate. The number of layers and thickness of the semiconductor doped multilayer structure is determined by the required breakdown voltage.

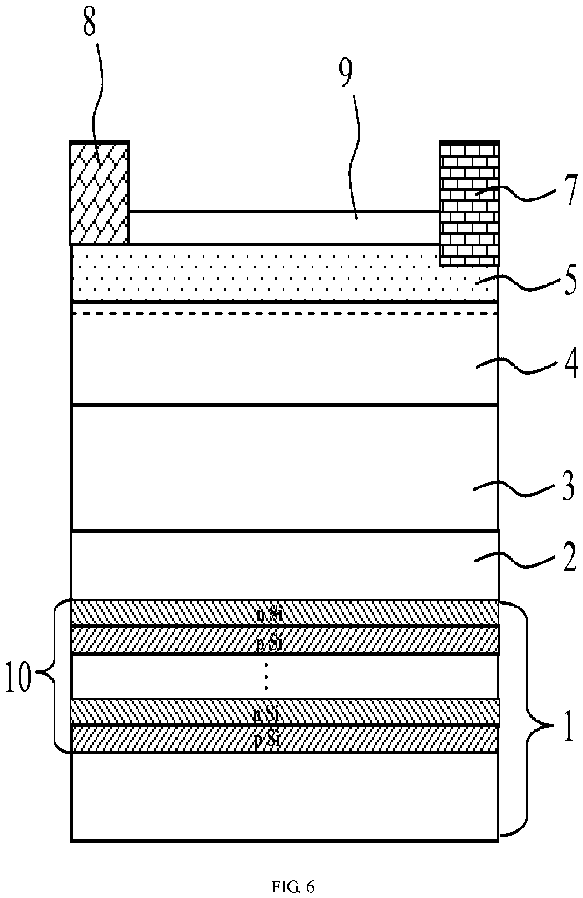

FIG. 6 is a schematic structural view illustrating a nitride power device on a silicon substrate according to a second example useful for understanding the present invention. In the second example, a diode device having a diode structure is taken as an example for description. The semiconductor doped multilayer structure is introduced in the silicon substrate of the nitride diode device, which can improve the reverse breakdown voltage of the diode. The electrode 8 is a Schottky junction and serves as a positive electrode of the diode, and the electrode 7 is an Ohmic contact and serves as a negative electrode of the diode.

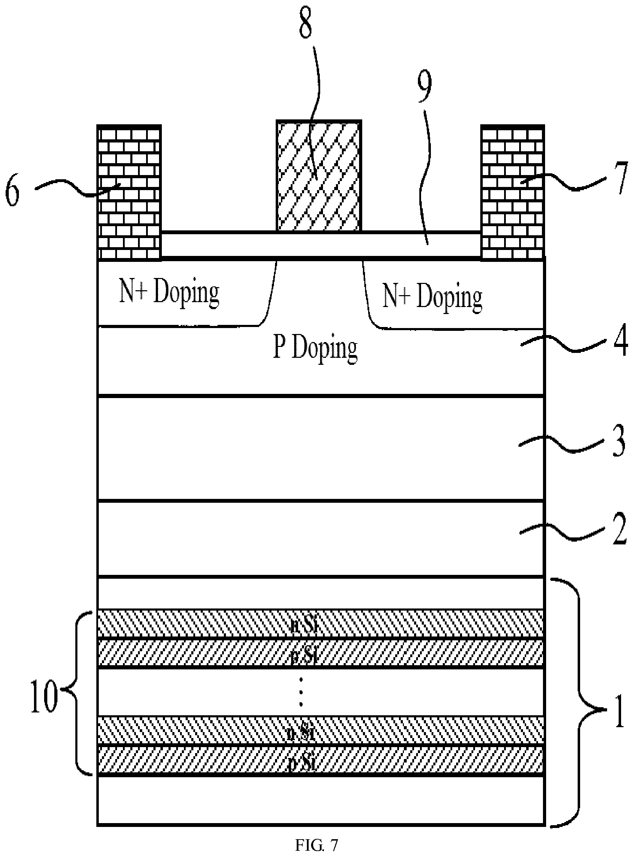

FIG. 7 is a schematic structural view illustrating a nitride power device on a silicon substrate according to a third example useful for understanding the present invention. In this example, a MOSFET device including another triode structure is taken as an example for description. The MOSFET device is a nitride n-channel MOSFET device in which the semiconductor doped multilayer structure is introduced in the silicon substrate of the device, which greatly increases the breakdown voltage. The regions below the source electrode and the drain electrode on the nitride channel layer are n-type heavily-doped regions in which silicon is usually doped. The region below the gate electrode is a p-type lightly-doped region in which magnesium is doped. The dielectric layer below the gate metal is usually SiO₂, SiN, AlN, Al₂O₃ or other insulation dielectric layer.

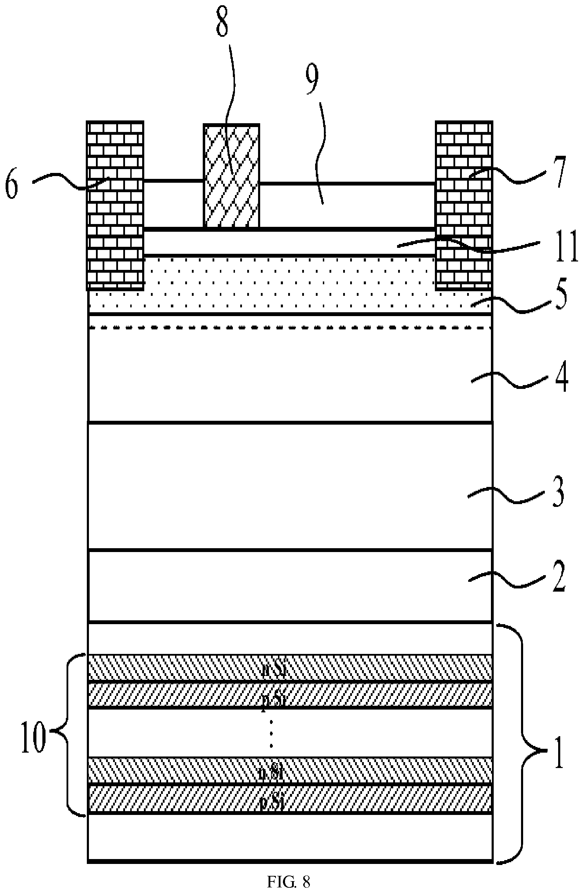

FIG. 8 is a schematic structural view illustrating a nitride power device on a silicon substrate according to a fourth example useful for understanding the present invention. A GaN capping layer 11 is grown on the barrier layer. Due to surface defect and high surface state density of the AlGaN barrier layer material, a large amount of electrons will be captured, which will affect the two-dimensional electron gas in the channel and hence reduce characteristics and reliability of the device. Growing a GaN layer on the surface of the barrier layer as a protection layer can effectively avoid impact on the characteristics of the device by the surface defect and the surface state density of the barrier layer material.

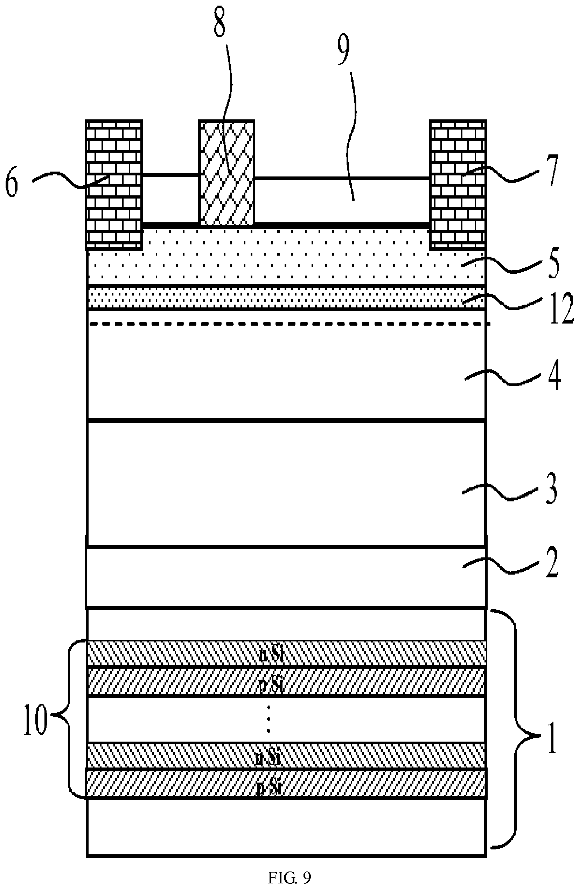

FIG. 9 is a schematic structural view illustrating a nitride power device on a silicon substrate according to a fifth example useful for understanding the present invention. An AlN insertion layer 12 is introduced between the barrier layer and the channel layer. Since AlN has a large band gap, electrons can be confined in a heterojunction potential well effectively, which increases the concentration of the two-dimensional electron gas. In addition, the AlN insertion layer separates the conductive channel from the AlGaN barrier layer, which reduces the scattering effect on electrons by the barrier layer, thus improving the mobility of electrons and improving the overall characteristics of the device.

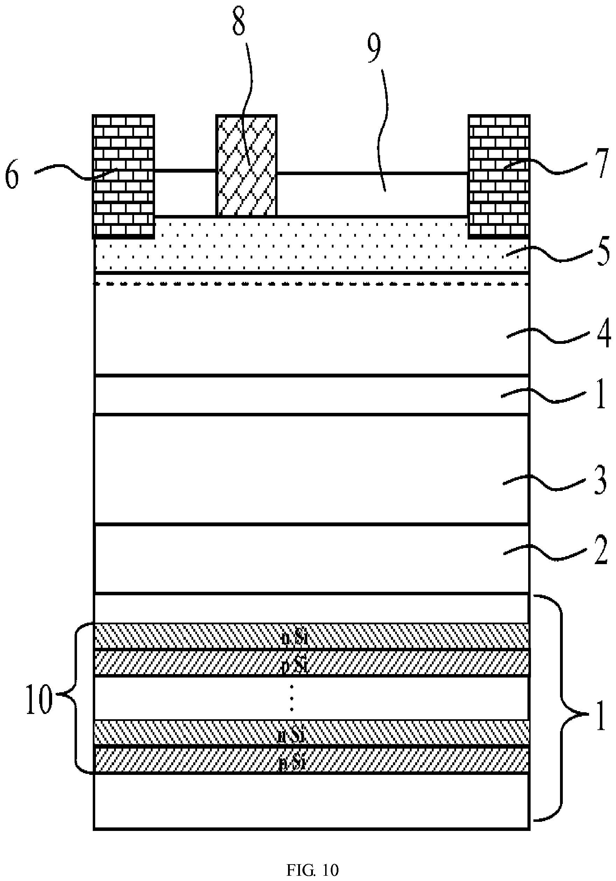

FIG. 10 is a schematic structural view illustrating a nitride power device on a silicon substrate according to a sixth example useful for understanding the present invention. An AlGaN back barrier layer 13 is introduced between the buffer layer and the channel layer. Under a certain external voltage, electrons in the channel will enter into the buffer layer. This phenomenon is more serious in a short-channel device. In this case, the control on electrons in the channel by the gate electrode becomes weak, leading to the short-channel effect. Moreover, there are a large amount of defects and impurities in the buffer layer, which affects the two-dimensional electron gas in the channel, for example results in current collapse. The AlGaN back barrier layer can separate the channel electrons from the buffer layer and effectively confine the two-dimensional electron gas in the channel layer, which avoids the short-channel effect and the current collapse effect.

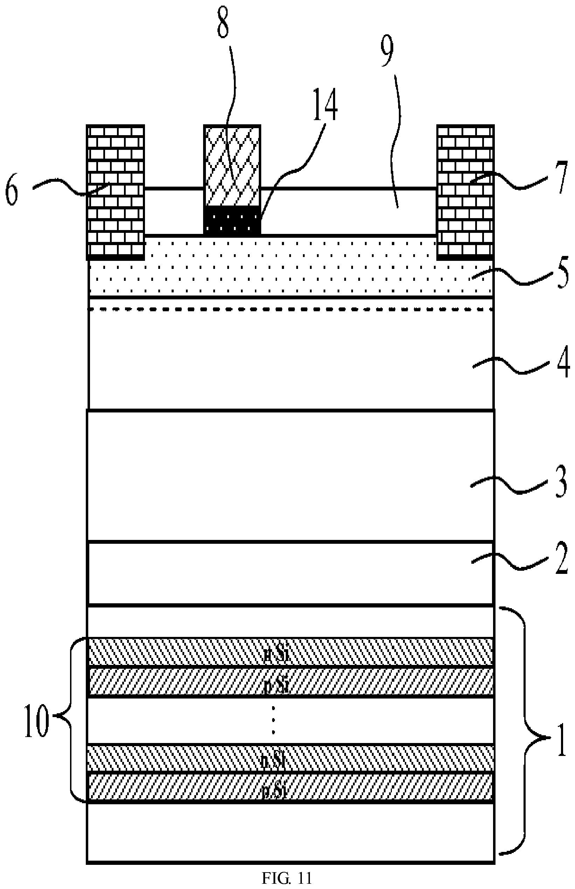

FIG. 11 is a schematic structural view illustrating a nitride power device on a silicon substrate according to a seventh example useful for understanding the present invention. An insulation dielectric layer 14 is inserted below the gate electrode to form a MISFET structure. The insulation dielectric layer serves as both a passivation layer of the device and a gate insulation layer, which can effectively reduce a gate leakage current. The insulation dielectric layer 14 includes one selected from SiN, Si02, SiON, Al₂O₃, HfO₂, HfAlOx or any combination thereof.

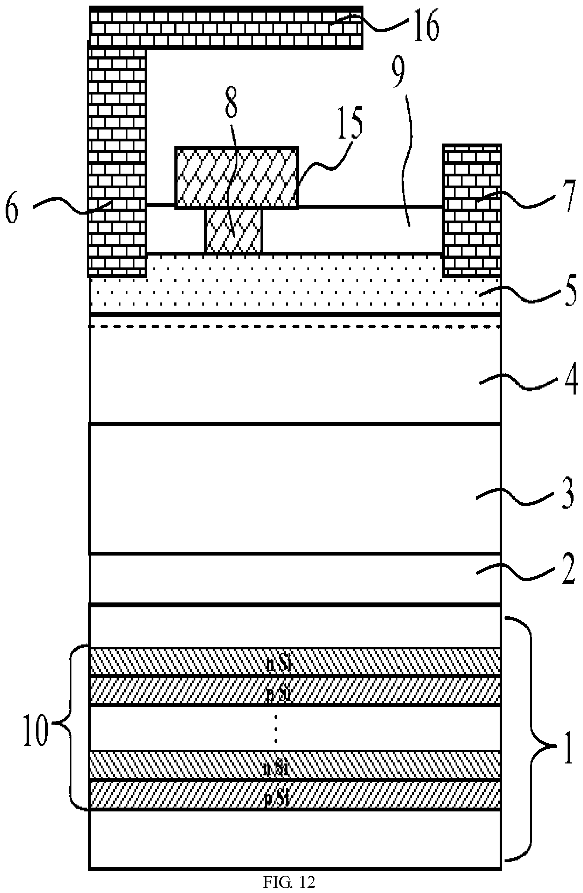

FIG. 12 is a schematic structural view illustrating a nitride power device on a silicon substrate according to an eighth example useful for understanding the present invention. A gate field plate 15 and/or a source field plate 16 are further disposed on the gate electrode 8 and/or the source electrode 6 of the nitride power device respectively. Introducing a field plate structure on the gate electrode and/or the source electrode can reduce the electric field strength of an end of the gate electrode adjacent to the drain electrode, reduce the gate leakage current and further increase the breakdown voltage of the device.

On the basis of the present invention, an enhanced nitride power device can be manufactured by changing the structure or manufacturing process of the nitride channel layer or the barrier layer on the silicon substrate, for example, by bombarding the material region below the gate metal with fluorine ions.

To sum up, the present invention provides a method for manufacturing a nitride power device on a silicon substrate. A semiconductor doped multilayer structure including n-type silicon layers and p-type silicon layers in an alternating arrangement is epitaxially grown on a silicon substrate to form a space charge depletion region, thereby increasing breakdown voltage of the device and reducing the risk of the device being broken down by a voltage.

Although a manufacturing method of a nitride power device according to the present invention has been described in detail with exemplary embodiments or examples, the embodiments or examples are not exhaustive, and various modification and changes can be made within the scope of the present invention by those skilled in the art. Therefore, the present invention is not limited to these embodiments or examples, the scope of the present invention is only limited by the appended claims.

## Claims

1. A manufacturing method of a nitride power device, comprising the following steps:
providing a silicon substrate having a top major surface and a bottom major surface;
epitaxially growing a semiconductor doped multilayer structure (10) forming a space charge depletion region on the bottom major surface of the silicon substrate (1);
growing an epitaxial multilayer structure on the top major surface of the silicon substrate (1), wherein the epitaxial multilayer structure comprises at least a nitride nucleation layer (2), a nitride buffer layer (3) formed on the nitride nucleation layer (2) and a nitride channel layer (4) formed on the nitride buffer layer (3); and
forming contact electrodes on the epitaxial multilayer structure, wherein the electrodes include a source electrode (6), a drain electrode (7) and a gate electrode (8) between the source electrode (6) and the drain electrode (7) when the nitride power device has a triode structure, and include a positive electrode and a negative electrode when the nitride power device has a diode structure,
wherein the semiconductor doped multilayer structure (10) consists of multiple pn junctions formed by multiple n-type silicon layers and multiple p-type silicon layers in an alternating arrangement, and the multiple pn junctions form multiple space charge depletion regions.

## Patentansprüche

1. Verfahren zur Herstellung eines Nitrid-Leistungsgeräts, umfassend die folgenden Schritte:
Bereitstellen eines Siliziumsubstrats mit einer oberen Hauptfläche und einer unteren Hauptfläche;
epitaktisches Wachsen einer halbleiterdotierten Mehrschichtstruktur (10), wodurch eine Raumladungs-Verarmungszone auf der unteren Hauptfläche des Siliziumsubstrats (1) gebildet wird;
Aufwachsen einer epitaktischen Mehrschichtstruktur auf der oberen Hauptfläche des Siliziumsubstrats (1), wobei die epitaktische Mehrschichtstruktur mindestens eine Nitridkristallisationsschicht (2), eine auf der Nitridkristallisationsschicht (2) gebildete Nitridpufferschicht (3), und eine auf der Nitridpufferschicht (3) gebildete Nitridkanalschicht (4) umfasst; und
Bilden von Kontaktelektroden auf der epitaktischen Mehrschichtstruktur, wobei die Elektroden eine Quellen-Elektrode (6), eine Ableitungs-Elektrode (7) und eine Gate-Elektrode (8) zwischen der Quellen-Elektrode (6) und der Ableitungs-Elektrode (7) umfassen, wenn das Nitrid-Leistungsgerät eine Triodenstruktur aufweist, und wobei die Elektroden eine positive Elektrode und eine negative Elektrode umfassen, wenn das Nitrid-Leistungsgerät eine Diodenstruktur aufweist,
wobei die halbleiterdotierte Mehrschichtstruktur (10) aus mehreren pn-Übergängen besteht, die aus mehreren n-artigen Siliziumschichten und mehreren p-artigen Siliziumschichten in einer alternierenden Anordnung gebildet werden, und die mehreren pn-Übergänge mehrere Raumladungs-Verarmungszonen bilden.

## Revendications

1. Un procédé de fabrication d'un dispositif électrique au nitrure, comprenant les étapes suivantes :
le fait de fournir un substrat de silicium ayant une surface supérieure principale et une surface inférieure principale ;
le fait de faire croître de façon épitaxiale une structure multicouche (10) dopée semi-conducteur formant une zone de déplétion de charge spatiale sur la surface principale inférieure du substrat (1) en silicium ;
le fait de faire croître une structure multicouche épitaxiale sur la surface principale supérieure du substrat (1) en silicium, la structure multicouche épitaxiale comprenant au moins une couche de nucléation (2) au nitrure, une couche tampon (3) au nitrure formée sur la couche de nucléation (2) au nitrure et une couche formant canal (4) au nitrure formée sur la couche tampon (3) au nitrure ; et
le fait de former des électrodes de contact sur la structure multicouche épitaxiale, les électrodes comprenant une électrode source (6), une électrode de drain (7) et une électrode de grille (8) située entre l'électrode source (6) et l'électrode de drain (7) lorsque le dispositif électrique au nitrure a une structure triode, et comprenant une électrode positive et une électrode négative lorsque le dispositif d'alimentation au nitrure a une structure de diode,
la structure multicouche (10) dopée semi-conducteur consistant en de multiples jonctions pn formées par de multiples couches de silicium de type n et de multiples couches de silicium de type p selon un agencement en alternance, et les multiples jonctions pn forment plusieurs zones de déplétion de charge spatiale.
